(19) Europäisches Patentamt
European Patent Office
Office européen des brevets

(11) **EP 2 345 753 B1**

(12) **EUROPEAN PATENT SPECIFICATION**

(45) Date of publication and mention
of the grant of the patent:
**04.07.2012 Bulletin 2012/27**

(51) Int Cl.:
*C30B 29/06* (2006.01)    *C30B 33/02* (2006.01)

(21) Application number: **10195014.5**

(22) Date of filing: **14.12.2010**

(54) **Silicon wafer and production method therefor**

Silizium-Wafer und Herstellungsverfahren dafür

Tranche de silicium et son procédé de production

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.12.2009 JP 2009299162**

(43) Date of publication of application:
**20.07.2011 Bulletin 2011/29**

(73) Proprietor: **Siltronic AG**
**81737 München (DE)**

(72) Inventor: **Nakai, Katsuhiko**
**Hikari Yamaguchi 743-0071 (JP)**

(74) Representative: **Staudacher, Wolfgang**
**Siltronic AG**
**Corporate Intellectual Property**
**Hanns-Seidel-Platz 4**
**81737 München (DE)**

(56) References cited:
EP-A1- 1 229 155      EP-A1- 1 406 294
EP-A2- 0 060 676      EP-A2- 0 502 471
WO-A1-93/20582        WO-A2-03/060982
JP-A- 8 213 403       JP-A- 58 056 343
JP-A- 2006 040 980    US-A- 4 851 358
US-B1- 6 222 252

- **SEIGÔ KISHINO ET AL: "A Defect Control Technique for the Intrinsic Gettering in Silicon Device Processing", JAPANESE JOURNAL OF APPLIED PHYSICS, JAPAN SOCIETY OF APPLIED PHYSICS, JP, vol. 23, 31 January 1984 (1984-01-31), pages L9-L11, XP008133530, ISSN: 0021-4922, DOI: DOI:10.1143/JJAP.23.L9**
- **FUMIO SHIMURA: "Semiconductor silicon crystal technology , PASSAGE", SEMICONDUCTOR SILICON CRYSTAL TECHNOLOGY, XX, XX, 1 January 1989 (1989-01-01), pages 361-367, XP002307370,**
- **P. FRAUNDORF, G.K. FRAUNDORF, F. SHIMURA: "Clustering of oxygen atoms around carbon and silicon", J. APPL. PHYS., vol. 58, no. 11, 1 December 1985 (1985-12-01), pages 4049-4055, XP002624639,**
- **SHIMURA F ET AL: "MULTISTEP REPEATED ANNEALING FOR CZ-SILICON WAFERS: OXYGEN AND INDUCED DEFECT BEHAVIOR", JOURNAL OF THE ELECTROCHEMICAL SOCIETY, ELECTROCHEMICAL SOCIETY. MANCHESTER, NEW HAMPSHIRE, US, vol. 129, no. 9, 1 September 1982 (1982-09-01), pages 2089-2095, XP000840676, ISSN: 0013-4651**
- **SHIMURA F: "REDISSOLUTION OF PRECIPITATED OXYGEN IN CZOCHRALSKI-GROWN SILICON WAFERS", APPLIED PHYSICS LETTERS, AIP, AMERICAN INSTITUTE OF PHYSICS, MELVILLE, NY, US, vol. 39, no. 12, 15 December 1981 (1981-12-15), pages 987-989, XP000817122, ISSN: 0003-6951, DOI: DOI: 10.1063/1.92636**

**Description**

The present invention relates to a silicon wafer and production technology therefor which is capable of suppressing generation of both slip dislocation and warpage, in a field of production technology of a semiconductor wafer, in particular, a device production process.

A silicon wafer to be used as a substrate for such as a semiconductor device is produced by slicing a single crystal silicon ingot, and performing heat treatment or mirror finishing or the like. Among them, due to reasons that it is easy to obtain the single crystal ingot having large diameter, or it is relatively easy to control defect, most of single crystal silicon ingot are produced by a Czochralski method (hereafter referred to as "a CZ method"). A single crystal silicon grown by such a CZ method (hereafter referred to as "CZ-Si") has "Grown-in defect" internally, in particular, supersaturated oxygen taken in among silicon lattices as a supersaturated state causes an inducement of micro defect called as Bulk Micro Defect (hereafter abbreviated as "BMD"), during heat treatment (anneal) thereafter.

In general, BMD existing inside a crystal just after the single crystal silicon growth (Grown-in defect, an oxygen deposit, dislocation, lamination defect or the like induced in a device production process) deteriorates device characteristics, therefore it is required no crystal defect in a formation region of a semiconductor device. However, on the other hand, it has also been revealed that BMD can be utilized effectively as a gettering site of heavy metals or increase in mechanical strength of the substrate, and thus at present, it is required to generate suitable BMD inside a silicon wafer.

In order to satisfy such requirements, there is used generally at present a method for forming an Intrinsic Gettering layer (hereafter referred to as "an IG layer") by annealing the silicon wafer at high temperature and inducing BMD inside the silicon wafer, as well as forming a Denuded Zone layer (hereafter referred to as "an DZ layer") having extremely low crystal defect by making grow-in defect on the surface of the silicon wafer disappear.

However, the DZ layer formed on the front and rear surfaces of the silicon wafer by the annealing process at high temperature, decreases number of BMD or dislocation, which adhered with oxygen or oxygen impurity or the like, accompanying with extreme decrease of oxygen concentration by outward diffusion of oxygen during the heat treatment, and extremely decreases suppression force against extension of dislocation defect at the front and rear surfaces of the silicon wafer. Therefore, dislocation defect (hereafter referred to as "slip") easily extends in a bulk from a minute flaw on the front and rear surfaces, which was introduced in the annealing step, raising a problem that strength of the silicon wafer decreases by extension of such slip dislocation. Further, such decrease of the silicon wafer strength could incur a state of wafer damage or wafer destruction during production steps. However, the DZ layer is indispensible in semiconductor device formation, therefore it has been required a silicon wafer which has the DZ layer and shows excellent strength properties. In particular, when annealing is performed for a wafer supported by a heat treatment boat or the like, a slip dislocation often extends from the part supported by the boat, because of a dislocation generated at the contact part of the silicon wafer and the boat. In addition, a slip dislocation may extend from the edge part of the silicon wafer.

In addition, in order to produce a device, such as a device typified by formation of a thermally oxidized film, or activation of a dopant injected into a source or drain region, heat treatment of the silicon wafer is essential. In general, heat treatment is classified to: batch heat treatment, where one packed treatment is performed by assembling longitudinally several tens to hundred pieces or more of wafers held horizontally; and single wafer heat treatment, where heat treatment is performed piece by piece. In heat treatment, generation of temperature distribution on the silicon wafer surface causes thermal stress on the surface in proportion to the distribution, and this thermal stress of over a certain value raises a problem of not only a minute level difference on the wafer surface called as slip aforementioned but also warpage of the silicon wafer.

Technologies to suppress and prevent the generation of such slip dislocation or warpage are known. For example, in JP-A-2008-166721, there is disclosed a technology to produce a silicon wafer, in which the predetermined amount of BMD plate is formed and an inter-lattice oxygen concentration is equal to or lower than $5 \times 10^{17}$ atoms/cm$^3$, by performing heat treatment at a temperature range of 600 to 750°C for 10 minutes to 10 hours, and then increasing the temperature up to 1000°C at a temperature increasing rate of 0.1°C /minute to 1°C /minute for 5 to 50 hours, and further subjecting a silicon substrate cut out from a silicon crystal to heat treatment at a temperature range of 1000 to 1250°C so that diffusion length of inter-lattice oxygen is below 20 to 30 μm.

In addition, in JP-A-2008-160069, there is disclosed a technology to produce a silicon wafer, in which the predetermined amount of octahedron BMD is formed and an inter-lattice oxygen concentration is equal to or lower than $5 \times 10^{17}$ atoms/cm$^3$, by performing heat treatment at a temperature range of 600 to 750°C for 30 minutes to 10 hours, and then increasing temperature up to 1000°C at a temperature increasing rate of 0.1 to 1°C /minute for 5 hours to 50 hours, and further by subjecting a silicon substrate wafer cut out from a silicon crystal to heat treatment at a temperature range of 1000 to 1250°C so that diffusion length of inter-lattice oxygen is 30 μm to 50 μm.

Further, in JP-A-2009-164155, there has been disclosed a technology to control the change of substitution-type carbon concentration and inter-lattice oxygen concentration inside a silicon wafer between the states before and after heat treatment, to be within a predetermined range, by keeping a heat treatment furnace by a low temperature heat treatment of 650 to 800°C thereafter setting maximal temperature at 700 to 1000°C and increasing the temperature at a temperature increasing rate of 0.1 to 2°C /minute; then taking a silicon substrate out at 600°C to 800°C; further inserting the silicon substrate inside the heat treatment furnace at a temperature of the furnace of 600 to 800°C; increasing temperature of the heat treatment furnace at a temperature increasing rate of 5 to 10°C /minute in a temperature range from in the insertion up to below 1100°C; and increasing temperature of the heat treatment furnace at a temperature increasing rate of 1 to 2°C /minute in a temperature range of 1100 to 1250°C; and keeping a temperature of the heat treatment furnace to be constant within 1000°C to 1250°C; thus performing a heat treatment at a high temperature of 1100 to 1250°C.

Kishino et al. disclose a defect control technique for intrinsic gettering in silicon device processing (Seigo Kishino et al., Japanese Journal of Applied Physics, Vol. 23, Jan. 31,1984, L9 -L.11).

EP 1 406 294 A1 discloses a method for manufacturing a silicon wafer wherein the silicon wafer is subjected to a heat treatment to impart a gettering capability thereto.

WO 93/20582 A1 discloses a method of preparing semiconductor wafers with intrinsic gettering capability.

JP 58/056343 A discloses a method comprising heating a silicon substrate with a temperature rising speed of 5 °C/min or less, and to a temperature of 950°C or less.

Shimura discloses a method for oxygen outdiffusion and denuded-zone formation (Fumio Shimura, Semiconductor Silicon Crystal Technology, Jan. 1, 1989, pp. 361-367).

EP 0 502 471 A2 discloses a method for the production of a semiconductor device, wherein a silicon crystal having an impurity carbon concentration exceeding 1.0 ppm is subjected to heat treatments to effect intrinsic gettering.

US6222252B1 discloses a semiconductor substrate containing bulk micro defects dispersed at a density of not less than $10^{11}$ micro defects/cm$^3$ in the interior thereof wherein boron is present throughout the semiconductor substrate at a concentration of $10^{18}$ to $10^{20}$ atoms/cm$^3$.

JP 8-213403 A discloses a semiconductor substrate having gettering capacity due to plate-like $SiO_2$ deposits and the manufacture thereof.

JP 2006-040980 A discloses a silicon wafer which has a DZ layer with extremely few crystal defects and excels in strength characteristics.

P. Fraundorf et al. disclose transmission electron microscope studies of carbon-doped Czochralski silicon (P. Fraundorf et al., Journal of Applied Physics, Vol. 58, No. 11, Dec. 1, 1985, pp. 4049-4055).

WO 03/060982 A2 disclose a silicon wafer having a controlled oxygen precipitation behavior such that a denuded zone extending inward from the front surface and oxygen precipitates in the wafer bulk sufficient for intrinsic gettering purposes are formed.

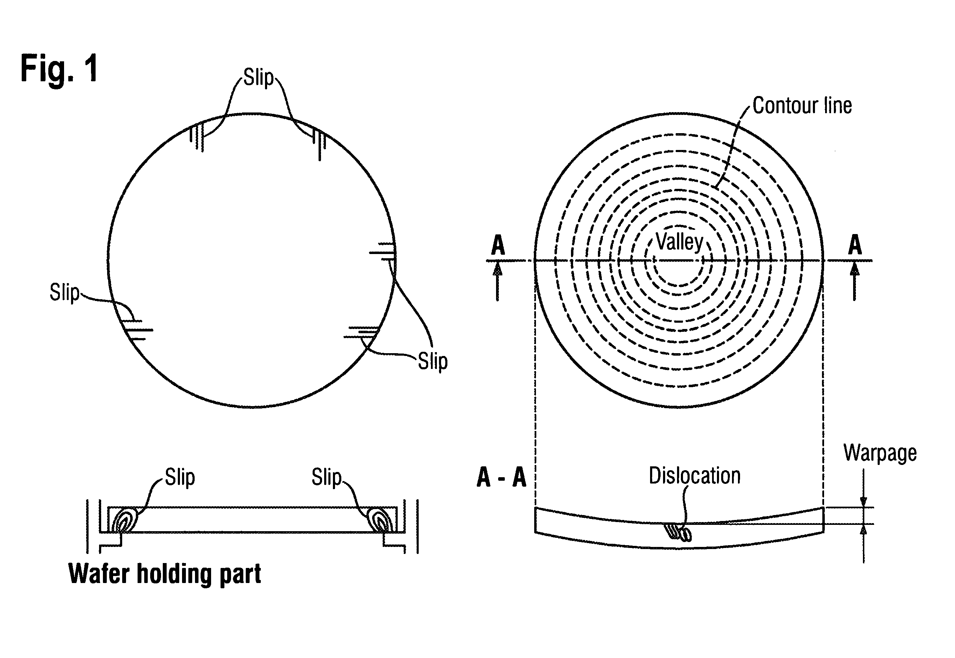

Fig. 1 shows a schematic diagram of a typical example of slip and warpage introduced by heat treatment. The slip is introduced from a contact point of the rear surface of the wafer and a wafer holding member or from the edge of the wafer. The introduced slip extends in a 110 direction and incurs wafer damage or destruction depending on the cases. The warpage is a phenomenon that the wafer deforms due to thermal strain in heat treatment. For example, a wafer of the 100 plane, as shown in Fig. 1, may exhibit concave-type warpage. Usually, warpage of the silicon wafer, before heat treatment is performed to bring desired characteristics, succeeds to be suppressed to equal to or smaller than 10 μm. However, the heat applied by heat treatment may generate a height difference of concave-convex of the silicon wafer that reaches several tens μm. Increased warpage disturbs correct exposure of a semiconductor device pattern to the wafer surface, and causes decreased yield of the semiconductor device.

The warpage problem tends to be significant when wafer diameter is equal to or larger than 200 mm, and is also significant when the heat treatment step of the device is performed in high temperature and long time. On the other hand slip dislocation decreases when BMD amount increases, and, warpage increases when BMD amount increases. Thus, it is known that the slip and warpage are in trade-off relation. Accordingly, there still is a problem that generation of slip and generation of warpage, in particular, generation of warpage cannot be suppressed and prevented effectively. Because, total density of BMD inside the silicon wafer results in a high concentration only by the technology, as disclosed in JP-A-2008-166721 and JP-A-2008-160069, in which concentration of density of relatively large BMD is decreased to suppress and prevent generation of warpage, concentration of density of relatively small BMD is increased to suppress and prevent generation of slip or slip length, and further shape of BMD is controlled to the predetermined morphology such as plate or octahedron to suppress and prevent generation of slip or slip length, so as to adjust inter-lattice oxygen concentration and then to secure oxygen adhered to BMD to the predetermined amount.

In addition, there is a problem that warpage cannot be suppressed and prevented effectively, only by a method, as disclosed in JP-A-2009-164155, for keeping number of oxygen or carbon adhered to BMD, by performing heat treatment so as to maintain carbon concentration and oxygen concentration existing in the silicon wafer as much as possible before heat treatment and after heat treatment, to the predetermined amount to the utmost, although generation of slip or slip length can be suppressed to some extent.

Therefore, a problem to be solved by the present invention is to provide a silicon wafer which is capable of suppressing generation of both slip dislocation and warpage during a device production process, and production technology therefor.

In view of the above problems, as a result of intensive study by the present inventors, the silicon wafer of the present invention is a silicon wafer according to claim 1.

In addition, a method for producing the silicon wafer of the present invention, to attain the above object, is a method according to claim 2.

According to the present invention, by attaining that the density of the BMD existing at position of a depth of equal to or deeper than 50 $\mu$m from the surface of the silicon wafer is equal to or higher than $1\times10^{11}$/cm$^3$, and the ratio of the {111} plane in total planes surrounding BMD, as morphology of the BMD, is equal to or lower than 0.3, generation of both of slip and warpage during the device production step can be suppressed to an extremely small level, and production of a device capable of preventing decrease in strength while having the DZ layer, and having large diameter (typically equal to or larger than 200 mm) and high quality is possible. The silicon wafer of the present invention prevents from generation of slip dislocation and has higher gettering capability than a mirror wafer not having BMD inside the wafer.

Fig. 1 is a drawing explaining slip and warpage caused by heat treatment of a silicon wafer.

Fig. 2 is a drawing showing relationship between shape of BMD and diagonal length of BMD.

Fig. 3 is a drawing showing relationship between shape of BMD and diagonal length of BMD.

Fig. 4 is a photograph image of BMD existing in the silicon wafer the present invention by a transmission electron microscope.

Fig. 5 is a drawing explaining dislocation generation place of BMD.

Fig. 6 is a photograph image of BMD where dislocation has generated by a transmission electron microscope.

Fig. 7 is a drawing showing a calculation method for the ratio of the {111} plane.

Fig. 8 is a graph of a change of heat treatment temperature relative to time in the production method of the present invention.

Fig. 9 is an outline cross-sectional view showing an example of a single crystal production apparatus to be used in the present invention.

A first aspect of the present invention is a silicon wafer having BMD with a diagonal length of 10 nm to 50 nm, wherein, a density of the BMD, which exists at position of a depth of equal to or deeper than 50 $\mu$m from the surface of the silicon wafer, is equal to or higher than $1\times10^{11}$/cm$^3$, and a ratio of the {111} plane in total planes surrounding BMD, as morphology of the BMD, is equal to or lower than 0.3.

Thereby, the present invention provides a silicon wafer which is capable of suppressing and preventing generation of both slip and warpage to an extremely small level, in a device production process. That is, BMD which exists at position of a depth of equal to or deeper than 50 $\mu$m from the surface of the silicon wafer of the present invention, gives influence on characteristics of slip or warpage; and further, among the influences, slip suppression effect of BMD having a diagonal length of equal to or longer than 10 nm is large, and in the silicon wafer formed with BMD of a high density of equal to or higher than $1\times10^{11}$/cm$^3$, generation of slip is suppressed to extremely low (typically equal to or smaller than 10 mm) in a general device production process. In addition, even in the case where slip generated from a wafer support part in the device production process, the invention can prevent the slip from going through the surface of the silicon wafer, or even in the case where slip generated at the wafer edge, reaching of the slip to a region of the semiconductor device formation can be prevented, and thus adverse influence on the device can be prevented.

Size (diameter, thickness) of the wafer attained by the present invention, and presence or absence of dope of various elements are not particularly limited, and these features can be selected, as appropriate, corresponding to kind of the semiconductor silicon wafer required. Further, there is also no especial limitation on the semiconductor device produced by using the silicon wafer of the present invention, and it is applicable to production of various semiconductor devices. Specifically, the silicon wafer of the present invention is applicable widely to produce such as an epitaxial wafer formed with an epitaxial layer on the surface, a laminated SOI wafer, an SIMOX wafer by SIMOX (Separation By Implanted Oxygen) treatment, or an SiGe wafer formed with an SiGe layer on the surface and the like.

The silicon wafer of the present invention has BMD with a diagonal length of 10 nm to 50 nm, at position of a depth of equal to or deeper than 50 $\mu$m from the surface thereof, and preferably has BMD with a diagonal length of 20 nm to 50 nm, at position of a depth of equal to or deeper than 50 $\mu$m from the surface thereof.

It is estimated that when diagonal length of BMD is 10 nm to 50 nm, slip suppression effect is exerted, because of strong barrier effect on slip propagation.

In addition, in such a range, the longer diagonal length and the higher density provide the higher effect of slip suppression, and thus it is preferable.

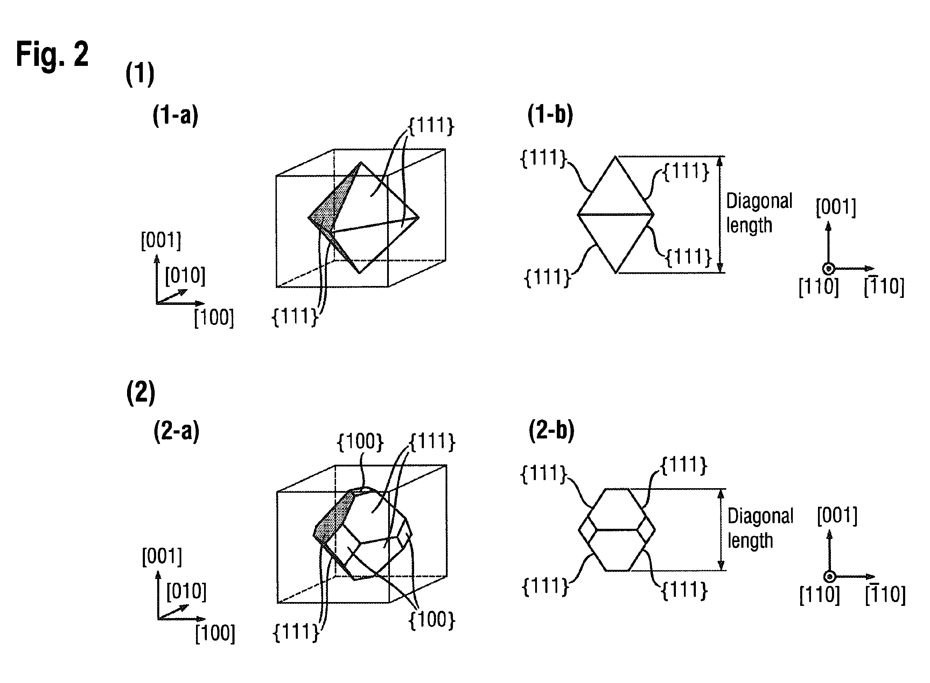

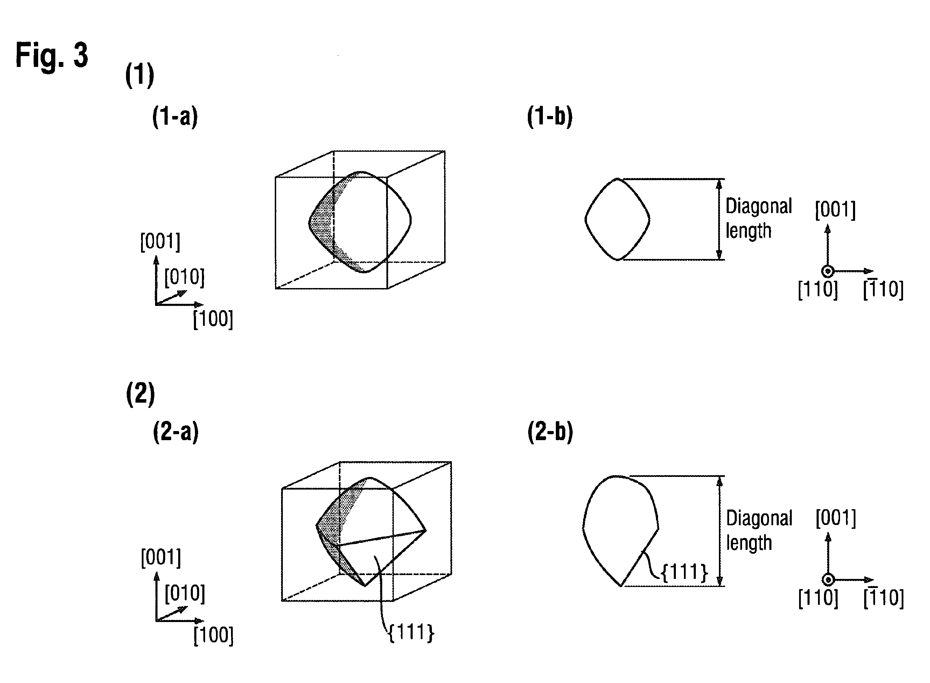

"Diagonal length of BMD" in the present description means length in a <100> direction, in a plane image of BMD projected orthogonally to any one of the {110} planes. For example, diagonal length of an octahedral BMD shown in Fig. 2(1) (1-a) is length in a [001] axis direction among Fig. 2(1) (1-b), which is an plan view projected orthogonally to the (110) plane; and diagonal length of an dodecahedral BMD, shown in Fig. 2(2) (2-a), is length in a [001] axis direction among Fig. 2(2) (2-b), which is an image projected orthogonally to the (110) plane. Similarly as above, Figs. 3(1) (1-a) and (1-b) show shape of an irregular BMD, and diagonal length thereof, respectively, and Figs. 3(2) (2-a) and (2-b) show shape of a partially irregular BMD, and diagonal length thereof, respectively. Diagonal length of BMD is a parameter relating to size of BMD.

Density of BMD existing at position of a depth of equal to or deeper than 50 $\mu$m from the surface of the silicon wafer of the present invention, is equal to or higher than $1 \times 10^{11}$/cm$^3$, and it is preferably from $1 \times 10^{12}$/cm$^3$ to $1 \times 10^{13}$/cm$^3$. The density of the relevant BMD of below $1 \times 10^{11}$/cm$^3$ makes slip suppression effect insufficient, and formation of BMD with a density of over $1 \times 10^{13}$/cm$^3$ is generally difficult by the following reason.

Solid solution oxygen included in general growth condition of a CZ single crystal is about $1 \times 10^{18}$ atoms/cm$^3$, and in a state that BMD is formed in a high density of equal to or higher than $1 \times 10^{11}$ /cm$^3$, almost all of them become a deposited state. Because there is an upper limit of the solid solution oxygen, it is generally difficult to form BMD having a diagonal length of equal to or longer than 10 nm, to be of a density of over $1 \times 10^{13}$ /cm$^3$, and it is also difficult generally to make size of BMD having a density of equal to or higher than $1x10^{11}$ /cm$^3$ to be over 50 nm.

In BMD existing in the silicon wafer of the present invention, the ratio of the {111} plane in total planes surrounding BMD, as morphology of the BMD, is equal to or lower than 0.3, and more preferably, the ratio of the {111} plane is equal to or lower than 0.1.

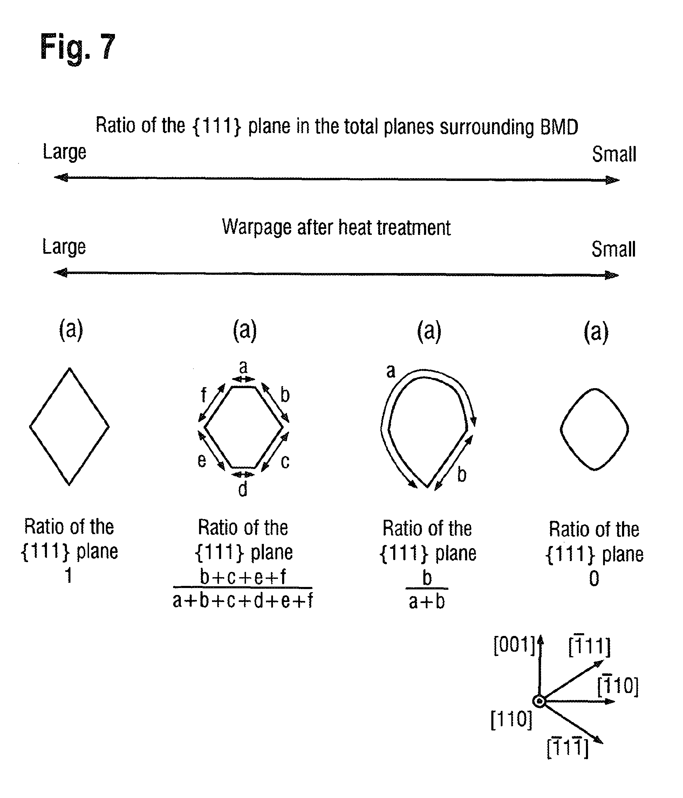

"Ratio of the {111} plane in total planes surrounding BMD" in the present description means: in a plane image of BMD projected orthogonally to any one of the {110} planes, (total length of vertical side to a <111> direction, that is, orthogonal projection of the {111} plane) / (total of circumference length). For example, in Fig. 7(a), which is a plan view where an octahedron-shaped BMD is orthogonally projected to the (110) plane, because BMD circumference is all a side vertical to the <111> direction, the ratio of the {111} plane is 1; and in Fig. 7(b), which is a plan view where a dodecahedral BMD is orthogonally projected to the (110) plane, because side b and side e are vertical to the [-111] direction, and side c and side f are vertical to the [-11-1] direction, the ratio of the {111} plane is (b + c + e + f) / (a + b + c + d + e + f). In Fig. 7(c), because side b is vertical to the [-11-1] direction, ratio of the {111} plane is b / (length of arc a + b); and because the clear [111] plane is not observed in Fig. 7(d), the ratio of the {111} plane is 0.

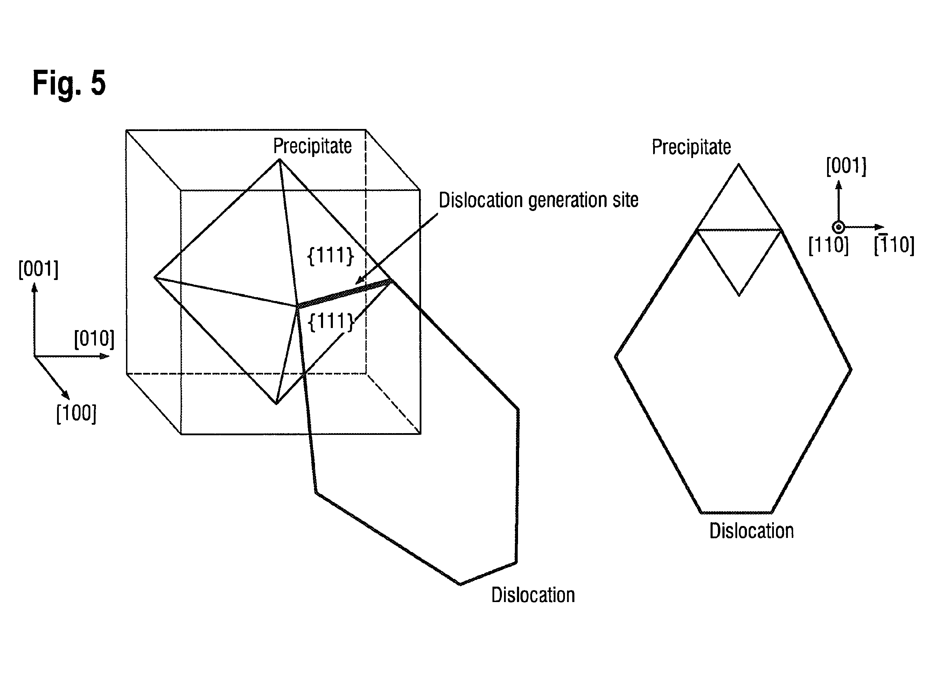

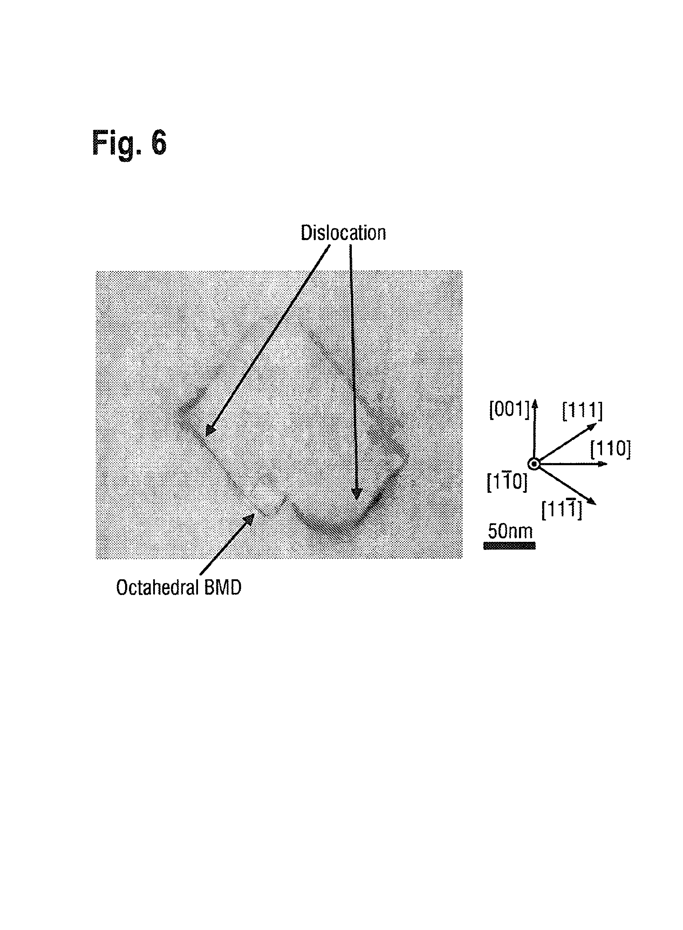

The present inventors have found that cause of warpage of the silicon wafer by heat treatment is generation of dislocation by BMD formed in a high density of equal to or higher than $1 \times 10^{11}$/cm$^3$. Further, by investigation of dislocation generation mechanism by the BMD, it was found that, as shown in Fig. 5, a region where the two {111} planes cross each other is a dislocation generation place (refer to Fig. 6). It is supposed that this region has increased strain, resulting in easy generation of dislocation.

That is, when thermal stress caused by heat treatment goes beyond critical value, plastic deformation generates and causes warpage of the silicon wafer, therefore, it is considered that presence of a large dislocation generation places where the two {111} planes cross each other, as shown in Fig. 5, brings lattice defect such as dislocation excessively inside the silicon wafer, by which critical value of thermal stress decreases and mechanical strength of the silicon wafer after heat treatment weakens, and thus warpage easily generates.

Fig. 6 shows a TEM photograph image of dislocation generated place, where the two {111} planes cross. Referring to Fig. 6, because the ridge of BMD, which is a generation place of the aforementioned dislocation, crosses with the {111} plane, it is considered that a dislocation generated at the ridge easily moves and extends on the {111} plane.

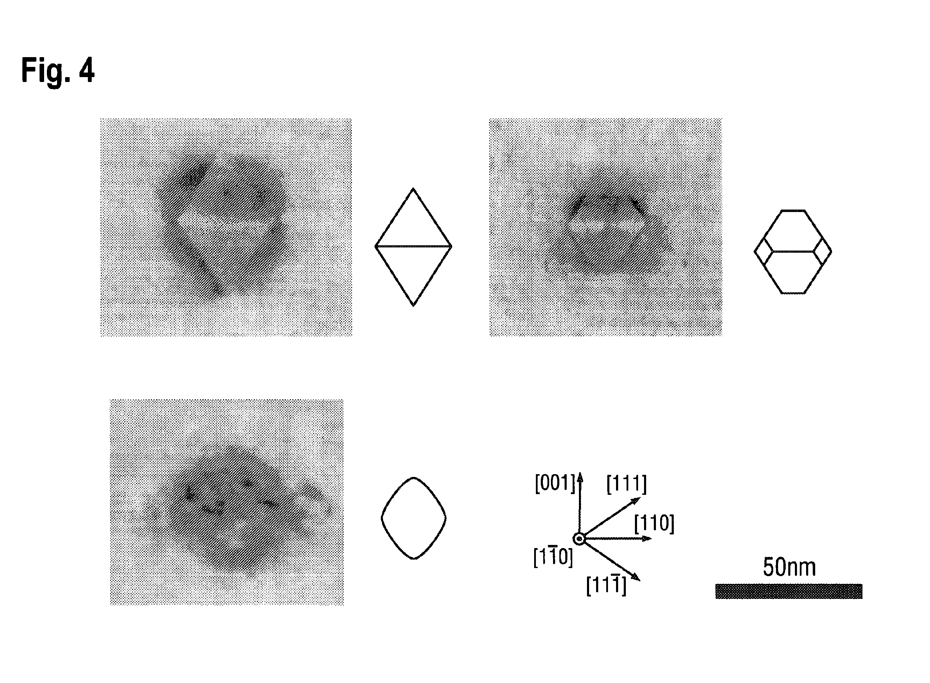

Based on the above findings, the present inventors have revealed that by controlling morphology of high density BMD formed inside the silicon wafer to be irregular BMD so as to have less {111} plane, as shown in Figs. 3(1) and (2), generation of dislocation at the BMD decreases, resulting in decrease in warpage of the wafer after heat treatment. Fig. 4 shows a TEM photo of typical BMD.

Here, as an index of morphology of BMD, the ratio of the {111} plane in total planes surrounding BMD is adopted. That is, as shown in Fig. 7, ratio of length of the {111} plane to total length of the circumference is determined, when BMD is projected in a <110> direction. As described in detail in Examples later, according to experiments by the present inventors, it was found that warpage amount after heat treatment is suppressed to equal to or smaller than 10 $\mu$m when a ratio of the {111} plane becomes equal to or lower than 0.3.

Based on the above results, the silicon wafer of the present invention is excellently superior in having small slip and warpage generating in the device production process. More specifically, the silicon wafer of the present invention, particularly in the silicon wafer having controlled size, density and morphology of BMD as above-described, is characterized in that length of the slip generating also in the heat treatment as following is extremely short (typically, the slip is equal to or shorter than 10 mm, and increase of warpage of the wafer after heat treatment is equal to or less than 10 $\mu$m).

In order to measure the morphology, diagonal length and number of the above-described BMD, measurement by a usually known method is possible. In more specifically, measurement by a transmission electron microscope (hereafter referred to as "TEM") is included. A measurement method and an evaluation method for slip dislocation and warpage amount of the silicon wafer of the present invention are not particularly limited. Measurement is possible by a usually known method: as a specific measurement method for slip dislocation in the present description, an X-ray topography is used; and as a specific measurement method for warpage amount in the present description, it is possible to evaluate by observation using FT-90A, manufactured by NIDEK Co., Ltd, or the like.

A second aspect of the present invention is a method for producing a silicon wafer, comprising the steps of subjecting a silicon substrate wafer obtained by cutting out a silicon crystal to heat treatment step (A), heat treatment step (B) and heat treatment step (C):

the heat treatment step (A) comprising the steps of:

inserting said silicon substrate wafer to a heat treatment furnace by setting a temperature thereof at 700°C to 800°C; increasing the temperature at a temperature increasing rate of 5°C /minute to 10°C /minute for a range of the insertion temperature of said silicon substrate wafer to a temperature of below 1100°C; increasing the temperature at a temperature increasing rate of 1°C /minute to 2°C /minute for a temperature range of from 1100°C to 1250°C; keeping the temperature to be a constant temperature of 1200°C to 1250°C for from 2 to 4 hours; decreasing the temperature of said heat treatment furnace at a temperature decreasing rate of 1°C /minute to 10°C /minute; taking out said silicon substrate wafer to outside of said heat treatment furnace at a temperature of 700°C to 800°; and cooling said silicon substrate wafer down to room temperature;

the heat treatment step (B) comprising the steps of: inserting said silicon substrate wafer to the heat treatment furnace by setting a temperature thereof at 700°C to 800°C; performing a heat treatment at the temperature being a constant temperature of 700°C to 800°C for 30 minutes to 5 hours; increasing the temperature at a temperature increasing rate of 0.5°C /minute to 2°C /minute, up to a temperature in which + 50°C is added to the constant temperature or higher; decreasing the temperature of said heat treatment furnace at a temperature decreasing rate of 1°C /minute to 10°C /minute; taking out said silicon substrate wafer to outside of the furnace at a temperature of 700°C to 800°C; and cooling the substrate down to room temperature;

the heat treatment step (C) comprising the steps of: inserting said silicon substrate wafer to the heat treatment furnace by setting the temperature thereof at 700°C to 800°C; increasing the temperature at a temperature increasing rate of 5°C /minute to 10°C /minute for a range of the insertion temperature of said silicon substrate wafer to a temperature of below 1100°C; increasing the temperature at a temperature increasing rate of 1°C /minute to 2°C /minute for a temperature range of from 1100°C to 1250°C; keeping the temperature to be a constant temperature of 1200°C to 1250°C for from 1 to 4 hours; decreasing the temperature of said heat treatment furnace at a temperature decreasing rate of 1°C /minute to 10°C /minute; and taking out said silicon substrate wafer to outside of said heat treatment furnace at a temperature of 700°C to 800°C.

Thereby, it is possible to produce a silicon wafer capable of suppressing generation of both of slip and warpage, in the device production step, to an extremely small level, and preventing the silicon wafer from decrease in strength while having the DZ layer, and having large diameter (typically equal to or larger than 200 mm) and high quality.

Hereinafter, explanation will be given on an example of the preferable production method for the silicon crystal of the present invention thereafter the production method for the silicon wafer of the present invention, by segmenting to each of the heat treatment steps (A) to (C).

(The production method for the silicon crystal)

The silicon crystal of the present invention is not particularly limited, as long as it is one obtained by a known production method such as the Czochralski method (including magnetic field applied MCZ or the like), a floating zone method, and one produced by the Czochralski method is preferable.

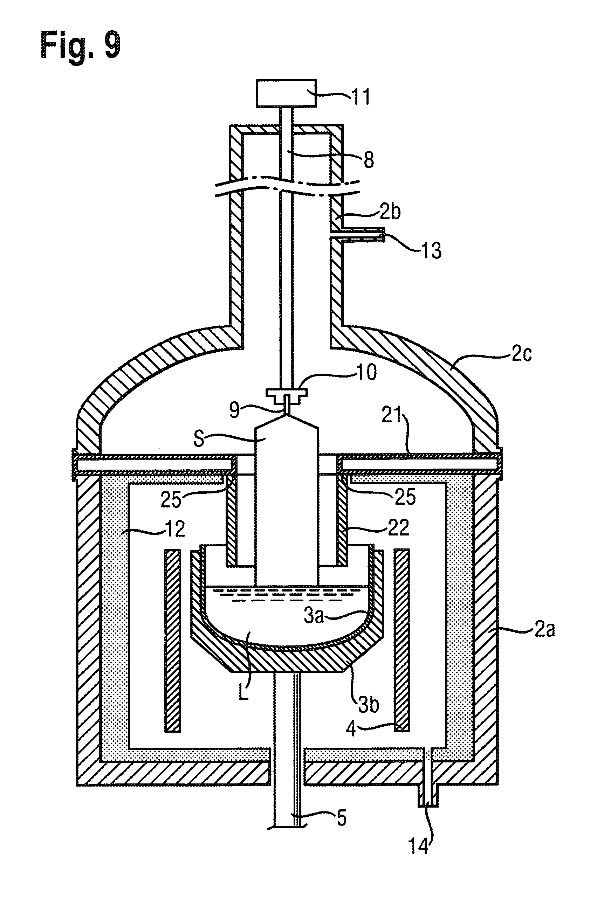

As for the production method of silicon crystal of the present invention, explanation will be given below on one example of preferable embodiments of the production method for the silicon crystal and the silicon wafer using a single silicon crystal production apparatus, with reference to examples, along with explanation on the relevant single crystal silicon production apparatus. Fig. 9 is a schematic cross-sectional view showing one example of a single crystal production apparatus to be used in the present invention. The single crystal production apparatus shown in Fig. 9 has a member for melting a semiconductor material and a mechanism for pulling up a grown single crystal; the member for melting a semiconductor material is held inside a heating chamber 2a; and the mechanism for pulling up the single crystal is equipped at the inside and the outside of a pull-up chamber 2b, which constitutes a part of an upper structure body made separable from this heating chamber 2a. This upper structure body has a intermediate chamber 2c as well.

Inside the heating chamber 2a, a crucible retaining molten liquid L is equipped by a rotation shaft 5, and this crucible is supported in a free rotation and free hoisting state, and the rotation shaft 5 is rotated and hoisted by a drive unit not shown. The drive unit ascends the crucible just by lowered changed of liquid surface to compensate lowering of the liquid surface accompanying with pulling up a single crystal S, and , in order to stir the molten liquid L, the unit rotates the crucible always in the predetermined rotation frequency. The crucible is constituted by a quartz crucible 3a, and a graphite crucible 3b protecting this. At the side wall of the crucible, a heater 4 for melting the silicon is arranged so as to surround its circumference. At the outside of this heater 4, an insulating material 12, to prevent direct radiation of heat from this heater 4 to the heating chamber 2a, is equipped so as to surround its circumference.

At the pull-up chamber 2b, a pull-up wire 8, which is hung through the top wall of the ceiling of the intermediate chamber 2c and one end thereof is fixed to a wire winder 11 is provided; and at the lower end of this pull-up wire 8, a chuck 10 for holding a seed crystal 9 is attached. The wire winder 11 pulls up the single crystal S growing gradually at the lower end side of the seed crystal 9, according to the growth speed thereof or the like, and at the same time, makes the crystal rotated always in an opposite direction to a rotation direction of the crucible.

From a gas inlet 13 formed at the holding part for the pull-up chamber 2b, a gas mixture of argon and hydrogen is introduced, and this mixed gas is discharged from a gas vent 14, after circulating the inside of the heating chamber 2a. Reason for circulating the mixed gas inside the chamber in this way is, as described above, to prevent contamination of $SiO_2$ gas or $CO_2$ gas into molten silicon liquid, because the gas generates inside the chamber accompanied with melting of silicon by heating with the heater 4.

At the upward of the crucible inside the chamber, a liquid cooling structure 21 and a cooling body 22 are arranged so as to surround the growing single crystal. The liquid cooling structure 21 is a structured body in which a liquid coolant is circulated inside. In Fig. 9, the liquid cooling structure 21 is configured as a water cooling chamber made of stainless steel, using water as the coolant.

The cooling body 22 made of a high thermal conductivity material is arranged so as to cool the growing single crystal S. A material composing the cooling body 22 can be selected from substances with high heat conductivity and heat radiation rate, for example, silver, a silver alloy, carbon, copper or the like. As a material with high heat conductivity, as well as having no concern of contamination of the molten liquid or the single crystal, use of silver or a silver alloy is most preferable. A method for coating gold or silver or an alloy thereof onto the surface of copper or a copper alloy can be adopted as well.

The cooling body 22 is jointed to the liquid cooling structure 21, and the jointed part of the cooling body 22 and the liquid cooling structure 21 forms an explosively jointed part 25 jointed explosively. In explosive jointing, materials themselves to be jointed are arranged in parallel each other with a suitable space apart. On one of materials, suitable amount of an explosive is mounted via a buffer material, and explosion of this one end is initiated with a detonator, to collide both materials with progress of explosion, and both metals show viscous fluid-like behavior at the collision point by very high deformation speed and high pressure, generating metal jet flow forward from the collision point. Because an oxidized film or a gas adsorbed layer on the metal surface is removed by this metal jet flow, a clean surface thus appeared is adhered closely by high pressure, and both materials joint completely with metal structure.

Because the joint part of the cooling body 22 and the liquid cooling structure 21 is explosively jointed, a good joint part is formed, irrespective of being a joint part of different kind of metals, and further it is possible to secure nearly 100% of contact ratio in the contact area. Therefore, heat transfer from the cooling body 22 to the liquid cooling structure 21 proceeds extremely good, and it is possible to decrease temperature of the cooling body 22. The cooling body 22 is arranged at position to shield radiation heat from the crucible or the molten liquid L to the single crystal S by taking nearly rotation symmetrical shape to the center axis of the growing single crystal S, and is jointed with the liquid cooling structure 21 at the upper part of the cooling body 22.

In Fig. 9, the cooling body 22 is shown to have cylinder shape, and contact area of the explosively jointed part 25 of the cooling body 22 and the liquid cooling structure 21 has nearly the same area of cross-section of the main body of the cooling body. As for surface property of the cooling body 22, by making the inner side of the cooling body 22 facing to the single crystal S black, heat radiation irradiating can be absorbed. The outer side of the cooling body 22 facing to the crucible can be a surface with high reflectance, so as to reflect heat radiation irradiating.

The liquid cooling structure 21 is a water cooling chamber having doughnut-like shape, and is arranged between the side wall of the intermediate chamber 2c and the heating chamber 2a.

Firstly, in producing the single crystal S, the upper structure body, having the pull-up chamber 2b, the intermediate chamber 2c and the liquid cooling structure 21 explosively jointed with the cooling body 22, is separated from the heating chamber 2a. Polycrystalline silicon material as a raw material, impurities of very trace amount as dopants (for example phosphorous in the case of an n-type, boron in the case of a p-type, etc., selected as appropriate to obtain a desired semiconductor), and if necessary, a nitrogen-containing substance and a carbon-containing substance are inputted into the crucible, and then the upper structure body is attached again to the heating chamber 2a. By turning the heater 4 on in this state, melting of the semiconductor material inside the crucible is waited. When the semiconductor material becomes a molten state, hydrogen is inputted, if necessary, into atmosphere inside the crystal pull-up furnace for growing the silicon crystal, and the pull-up wire 8 is descended by actuating the wire winder 11, so that the seed crystal 9 attached to the chuck 10 contacts with the surface of the molten liquid L. When the single crystal S starts to growing on the seed crystal 9, in this state, then by pulling up the wire winder 11 at the predetermined speed, the single crystal S is made grown.

A method for adding nitrogen or carbon to the silicon crystal (or the silicon substrate wafer cut out from the silicon crystal grown) is not particularly limited, and a conventionally known method can be used preferably. In more specifically, as the addition method of nitrogen, by adding a silicon substrate having a nitride film to molten liquid for pulling up the silicon crystal, nitrogen concentration of the resultant silicon substrate wafer can be adjusted; and as the addition method of carbon, by adding carbon powder to molten liquid for pulling up the silicon crystal, carbon concentration of the resultant silicon substrate wafer can be adjusted.

Thus, in the process of growing the single crystal S while pulling up from the molten liquid L, radiant light from the single crystal S irradiates the cooling body 22 made of a high thermal conductivity material. Because the cooling body 22 is explosively jointed with the liquid cooling structure 21 cooled by a liquid coolant and kept at low temperature, exchange of the radiation heat with the single crystal S is good, and cooling rate of the single crystal S can be enhanced. In addition, because rapid cooling of the single crystal S during pulling up is possible, generation of crystal defect of the single crystal S decreases extremely.

Then, the pulled up single crystal S, which is the silicon crystal of the present invention, can be obtained. By cutting out the single crystal S pulled up, and by polishing (mirror finishing) if necessary, the silicon substrate wafer (or a mirror wafer) of the present invention can be obtained. By subjecting the silicon substrate wafer obtained here to the heat treatment steps (A) to (C) of the present invention, the silicon wafer of the present invention can be produced.

The silicon substrate wafer of the present invention can be prepared as a desired one, specifically, by suitably controlling single crystal growth conditions (crystal pulling up rate, crystal cooling rate, crucible rotation, gas flow and the like). In addition, limitation of size (diameter, thickness or the like) of the silicon wafer (or the silicon substrate wafer) of the present invention, and limitation of presence or absence of dope of various elements are not especially required, and they can be selected as appropriate in response to kind and performance of the silicon wafer required.

"Silicon substrate wafer" in the present description means the silicon wafer which is not heat-treated before the heat treatment steps (A) to (C) of the present invention, including wafers subjected to a step other than the heat treatment such as chamfering as appropriate after cutting out the silicon crystal of the present invention. "Silicon wafer" in the present description means wafers after performing the heat treatment steps of the present invention.

(The heat treatment step (A))

The heat treatment step (A) of the present invention comprises the steps of: inserting the silicon substrate wafer to a heat treatment furnace by setting a temperature thereof at 700°C to 800°C; increasing the temperature at a temperature increasing rate of 5°C /minute to 10°C /minute for a range of the insertion temperature of the silicon substrate wafer to a temperature of below 1100°C; increasing the temperature at a temperature increasing rate of 1°C /minute to 2°C /minute for a temperature range of from 1100°C to 1250°C; keeping the temperature to be at a constant temperature of 1200°C to 1250°C for from 2 to 4 hours; decreasing the temperature of the heat treatment furnace at a temperature decreasing rate of 1°C /minute to 10°C /minute; taking out the silicon substrate wafer to outside of the heat treatment furnace at a temperature of 700°C to 800°C; and cooling the silicon substrate wafer down to room temperature.

As for effect of the step (A) on morphology of BMD, it is understood as follows. Usually, after growth of the silicon crystal, in cooling process of the crystal to room temperature, oxygen, point defects, and other elements in the silicon crystal aggregate to form micro BMD nuclei, which exist in the silicon substrate wafer. By subjecting such silicon substrate wafer to heat treatment, oxygen aggregates around these BMD nuclei as the center to form BMD with observable size. BMD formed in such a process tends to a morphology accompanying the {111} plane. On the other hand, in the case where the silicon substrate wafer is subjected to heat treatment at equal to or higher than 1200°C, such as the heat treatment step (A), the micro BMD nuclei dissolve once. After that, it is understood that by forming the BMD nuclei again in the heat treatment step (B), and growing it in the heat treatment step (C), along with by effect of carbon or hydrogen to be described later, BMD, which is difficult to accompany the {111} plane, is formed.

In the step A, if the furnace temperature when inserting the silicon substrate wafer inside the furnace is set at below 700°C, it incurs decrease in life time of a furnace heater and thus it is not preferable, while the temperature of over 800°C deteriorates a furnace member and thus it is not preferable.

Reason for setting a temperature increasing rate of from 5°C /minute to 10°C /minute for a range of insertion temperature of the silicon substrate wafer to a temperature of below 1100°C, and a temperature increasing rate of from 1°C /minute to 2°C /minute or a temperature range of 1100°C to 1250°C is that such temperature increasing rate can be attained by a general heat treatment furnace, and can be a temperature increasing rate which shortens total heat treatment time.

In the step for keeping the wafer at a constant temperature, reason for setting the temperature equal to or higher than 1200°C or the time equal to or longer than 2 hours is because it is capable of making the ratio of the {111} plane of BMD to equal to or lower than 0.3, and suppressing warpage to equal to less than 10 $\mu$m, after completion of the high temperature heat treatment step of the heat treatment step (C).

The temperature of the heat treatment furnace of over 1250°C causes severe deterioration of an annealing furnace member, and thus it is not preferable, while the time for keeping at a constant temperature of over 4 hours is not preferable due to decrease in productivity. Temperature decreasing rate is preferably from 1°C /minute to 10°C /minute, which can be attained by a general furnace. The furnace temperature of below 700°C, when taking out the substrate to the outside of the furnace incurs the decrease in life time of the furnace heater, and thus it is not preferable, while the temperature of over 800°C deteriorates the furnace member, and thus it is not preferable.

(The heat treatment step (B))

The heat treatment step (B) of the present invention comprises the steps of: inserting the silicon substrate wafer to the heat treatment furnace by setting a temperature thereof at 700°C to 800°C; performing a heat treatment at the temperature being a constant temperature of 700°C to 800°C for 30 minutes to 5 hours; increasing the temperature at a temperature increasing rate of 0.5°C /minute to 2°C /minute, up to a temperature in which + 50°C is added to the constant temperature or higher; decreasing the temperature of the heat treatment furnace at a temperature decreasing rate of 1°C /minute to 10°C /minute; taking out the silicon substrate wafer to outside of the furnace at a temperature of 700°C to 800°C; and cooling the substrate down to room temperature.

By performing the relevant heat treatment step (B), the micro BMD nuclei dissolved once in the heat treatment step (A) can be formed again.

In the heat treatment step (B), the heat treatment furnace temperature of below 700°C does not provide BMD formation sufficiently because of insufficient diffusion of oxygen, and thus it is not preferable, while even when the temperature is over 800°C, there are many uselessness, because there is little influence on BMD optimization, and thus it is not preferable.

The time of heat treatment, performed at a constant temperature of from 700°C to 800°C, of below 30 minutes is insufficient as time for formation of BMD nuclei, while the time of over 5 hours decreases productivity extremely, and thus it is not preferable.

Further, the temperature increasing rate of the low rate region of below 0.5°C /minute cannot secure stable temperature increasing rate, while the temperature increasing rate of over 2°C /minute could disappear BMD deposited, and thus it is not preferable. When the final temperature of the temperature increasing step is below a temperature which is + 50°C higher than the keeping temperature of the low temperature heat treatment step, the BMD, which was formed during temperature increase, vanishes in the next step C, and thus it is not preferable.

(The heat treatment step (C))

The heat treatment step (C) of the present invention comprises the steps of: inserting the silicon substrate wafer to the heat treatment furnace by setting a temperature thereof at 700°C to 800°C; increasing the temperature at a temperature increasing rate of 5°C /minute to 10°C /minute for a range of the insertion temperature of the silicon substrate wafer to a temperature of below 1100°C; increasing the temperature at a temperature increasing rate of 1°C /minute to 2°C /minute for a temperature range of 1100°C to 1250°C; keeping the temperature to be a constant temperature of 1200°C to 1250°C for from 1 to 4 hours; decreasing temperature of the heat treatment furnace at a temperature decreasing rate of 1°C /minute to 10°C /minute; and taking out the silicon substrate wafer to outside of the heat treatment furnace at a temperature of from 700°C to 800°C.

By performing the heat treatment step (C), BMD nuclei, which are difficult to accompany the {111} plane, can be grown.

It is considered that in the heat treatment step (C), by setting the keeping temperature at equal to or higher than 1200°C, or the retention time at equal to or longer than 1 hour, it is possible to attain the diagonal length of BMD of equal to or longer than 10 nm by growth of the BMD nuclei, then, slip after the heat treatment can be suppressed to equal to or less than 10 $\mu$m by slip shielding effect.

It is considered that by subjecting the silicon substrate wafer to the heat treatment, which includes these heat treatment steps (A) to (C) as an inseparable one set, BMD which is difficult to accompany with the {111} plane is formed, then, generation of slip and warpage in the device production process can be both extremely suppressed.

Atmosphere of the heat treatment steps (A) to (C) is not particularly limited, and they may be performed under nitrogen atmosphere, hydrogen atmosphere, oxygen atmosphere, rare gas (Ar or the like) atmosphere; and there is no limitation on apparatus to be used in the heat treatment steps (A) to (C), and a conventionally known apparatus can be used preferably. Specifically, a usual batch-system vertical-type furnace, a batch-system vertical-type furnace having RTA (rapid thermal treatment) or oxygen purging function etc. are included.

As for the production method for the silicon wafer of the present invention, the silicon substrate wafer of the present invention contains nitrogen. It is because by containing nitrogen in the substrate, increase amount of warpage can be further suppressed to a small level (typically, equal to or smaller than 5 $\mu$m). Thus, it is because, by further suppressing increase amount of warpage, a higher performance device can be produced.

Nitrogen concentration inside the silicon substrate wafer of the present invention is $1.5\times10^{14}$ atoms/cm$^3$ to $5\times10^{15}$ atoms/cm$^3$, and preferably $4\times10^{14}$ atoms/cm$^3$ to $5\times10^{15}$ atoms/cm$^3$. The nitrogen concentration of below the above range makes surface defect remained after high temperature heat treatment, and thus it is not preferable, while the nitrogen concentration of over the above range generates polycrystallization and could decrease yield, and thus it is not preferable.

In the production method for the silicon wafer of the present invention, the silicon substrate wafer of the present invention contains carbon. Carbon concentration is from $3 \times 10^{15}$ atoms/cm$^3$ to $2 \times 10^{17}$ atoms/cm$^3$, and preferably from $5 \times 10^{15}$ atoms/cm$^3$ to $1 \times 10^{17}$ atoms/cm$^3$. The carbon concentration of below the above range makes the ratio of the {111} plane of BMD after completion of the high temperature heat treatment step (C) be over 0.3, and thus it is not preferable, while the carbon concentration of over the above range generates polycrystallization and could decrease yield, and thus it is not preferable.

In the production method for the silicon wafer of the present invention, the oxygen concentration of the silicon substrate wafer of the present invention is from $8 \times 10^{17}$ atoms/cm$^3$ to $9 \times 10^{17}$ atoms/cm$^3$. The relevant oxygen concentration of below the above range causes BMD density to be below $1 \times 10^{11}$ /cm$^3$, and thus it is not preferable, while the oxygen concentration of over the above range could decrease yield of the crystal, and thus it is not preferable.

In the production method for the silicon wafer of the present invention, the hydrogen partial pressure inside the crystal pull-up furnace when pulling-up the silicon crystal is 3 to 40 Pa, and preferably 30 to 40 Pa. The setting of the hydrogen partial pressure to be 3 to 40 Pa can make the ratio of the {111} plane of BMD to be equal to or lower than 0.3, because of the addition of constant amount of hydrogen into the crystal along with by effect of carbon. The case where the hydrogen partial pressure inside the silicon crystal pull-up furnace is below 3 Pa or over 40 Pa decreases pulling up yield of the crystal, and thus it is not preferable.

It is further preferable that for the silicon crystal of the present invention, nitrogen and carbon are doped in the silicon melt liquid, and the silicon crystal is grown under gas atmosphere including hydrogen inside the silicon crystal pull-up furnace. And, it is further preferable that hydrogen partial pressure inside the crystal pull-up furnace for growing the silicon crystal is 3 to 40 Pa, and nitrogen of $4 \times 10^{14}$ to $5 \times 10^{15}$ atoms/cm$^3$ and carbon of $5 \times 10^{15}$ to $1 \times 10^{17}$ atoms/cm$^3$ are added into the silicon molten liquid.

In the production method the present invention, the cooling rate in pulling-up the silicon crystal at 1000°C to 900°C is equal to or higher than 5°C/minute. The cooling rate of below the above range provides the ratio of the {111} plane of BMD of over 0.3, after completion of the heat treatment step (C), and thus it is not preferable.

Carbon concentration, nitrogen concentration and oxygen concentration in the silicon crystal, and carbon concentration, nitrogen concentration and oxygen concentration in the resultant silicon wafer are substantially the same.

The present invention comprises setting hydrogen partial pressure inside a crystal pull-up furnace for growing said silicon crystal at from 3 to 40 Pa and controlling a cooling rate of said silicon crystal at 1000°C to 900°C to be equal to or higher than 5°C/minute, nitrogen concentration of the silicon substrate wafer obtained by cutting out said silicon crystal is from $1.5 \times 10^{14}$ atoms/cm$^3$ to $5 \times 10^{15}$ atoms/cm$^3$; and oxygen concentration is from $8 \times 10^{17}$ atoms/cm$^3$ to $9 \times 10^{17}$ atoms/cm$^3$; and carbon concentration is $3 \times 10^{15}$ atoms/cm$^3$ to $2 \times 10^{17}$ atoms/cm$^3$ (as converted by JEITA).

The silicon wafer of the present invention shows synergistic effect, by doping nitrogen and carbon to the silicon molten liquid as above, and also by using the silicon substrate wafer grown under gas atmosphere including hydrogen inside the silicon crystal pull-up furnace, in addition to the heat treatment steps (A) to (C), can suppress and prevent generation of slip and warpage, and generation of slip dislocation in the device production process.

A measurement method for concentrations of nitrogen, carbon and oxygen included in the silicon substrate wafer and the silicon wafer of the present invention is not particularly limited as well, and they can be measured preferably by a conventionally known method. More specifically, as the method for measuring nitrogen concentration, nitrogen concentration can be measured by using a secondary ion mass spectrometer (SIMS). As the method for measuring oxygen and carbon concentrations, these concentrations can be measured by using an infrared absorption method, and determined by value of JEITA (Japan Electronics and Information Technology Industries Association) as a conversion factor.

**EXAMPLES**

Explanation will be given below on Examples of the present invention. However, the present invention should not be limited to the following Examples. That is, the following Examples are merely exemplifications, and any one should be encompassed in a technological scope of the present invention, as long as it has technological concept and substantially same constitution and exerts similar action effect as described in the claims of the present invention.

**Example 1**

Pulling-up of a single crystal silicon was performed using a silicon crystal production apparatus. The silicon crystal production apparatus used in the present Example is a single crystal production apparatus having the cooling body 22, shown in Fig. 9. Such an apparatus is used in a silicon crystal production by the usual CZ method, and crucible diameter used in the apparatus was 22 inch, a silicon semiconductor material introduced in the crucible was 100 kg, and the single crystal S grown was an 8 inch crystal.

Silver was used as a material of the cooling body 22, and inner diameter of the cooling body 22 was 260 mm, outer diameter thereof was 300 mm and length thereof was 280 mm. As the liquid cooling structure 21, such a configuration was used that the liquid cooling structure 31 was set as a doughnut-shaped water cooling chamber having a cooling water pipeline inside and attached to the lower part of the intermediate chamber 2c.

Specifically, the relevant production apparatus is a pull-up furnace 1 where a heat shielding body 36 was cooled by the above method for increasing pulling-up rate at equal to or higher than 1100°C; or a pull-up furnace 2 having general pulling-up rate. In the pull-up furnace 1, a joint part of the cooling body 22 and the liquid cooling structure 21 was explosively jointed. On the other hand, in the pull-up furnace 2, a joint part of the cooling body 22 and the liquid cooling structure 21 was bolt jointed.

The pull-up furnace 1 was used to attain the cooling rate of 5°C /minute at 900°C to 1000°C, and the pull-up furnace 2 was used to attain 2°C /minute.

The silicon crystal grown by utilizing this apparatus was p-type (boron doped-type) of a conduction-type, and crystal size (diameter) was 200 mm (8 inch).

The addition of nitrogen was performed by inputting a wafer having a nitride film into the silicon molten liquid. The addition of carbon was performed by inputting carbon powder into the silicon molten liquid. Nitrogen concentration of the silicon wafer obtained by slicing the crystal pulled-up was measured by using a secondary ion mass spectrometer (SIMS). Oxygen and carbon concentrations were measured by an infrared light absorption method, using value of JEITA (Japan Electronics and Information Technology Industries Association). That is, the conversion factor of inter-lattice oxygen concentration is $3.03 \times 10^{17}/cm^2$, and the conversion factor of carbon concentration is $8.1 \times 10^{16}/cm^2$.

The wafer having a nitrogen concentration of equal to or lower than $5 \times 10^{14}$ atoms/cm$^3$ cannot be measured by using SIMS, therefore nitrogen concentration determined by the following expression was used. Explanation will be given below in detail on such an expression.

The method for adding nitrogen in the production method of the present invention is not particularly limited, and known methods can be used, these include for example, a method for introducing nitrogen gas during dissolving a silicon raw material; a method for mixing a silicon substrate deposited with a nitride by a CVD method or the like, during dissolving a raw material. Segregation coefficient k, which is ratio of impurities taken in the crystal after solidification of the silicon molten liquid, relative to concentration in the molten liquid, is $7 \times 10^{-4}$ for the case of nitrogen (W. Zulehner and D. Huber, Crystal Growth, Properties and Applications, p28, Springer-Verlag, New York, 1982).

Nitrogen concentration taken into the crystal from the silicon molten liquid to be used in the production method of the present invention is calculated as follows:

```
Expression 1

Nitrogen concentration in the wafer = k × (1- solidification

rate) (k-1) × nitrogen concentration in the molten liquid
```

Nitrogen concentration in the molten liquid may also be called as initial nitrogen concentration in the molten liquid. Here, solidification rate (g) of the silicon crystal is determined as follows:

```
Expression 2

Solidification rate (g) of the silicon crystal = (weight of

silicon crystallized) / (initial molten liquid weight)
```

Measurement values [atoms/cm$^3$] of nitrogen concentration are described in the following Table 1.

The addition of hydrogen was performed by introducing hydrogen mixed gas to each of the pulling-up furnaces. As the hydrogen partial pressure [Pa], conditions described in the following Table 1 were set.

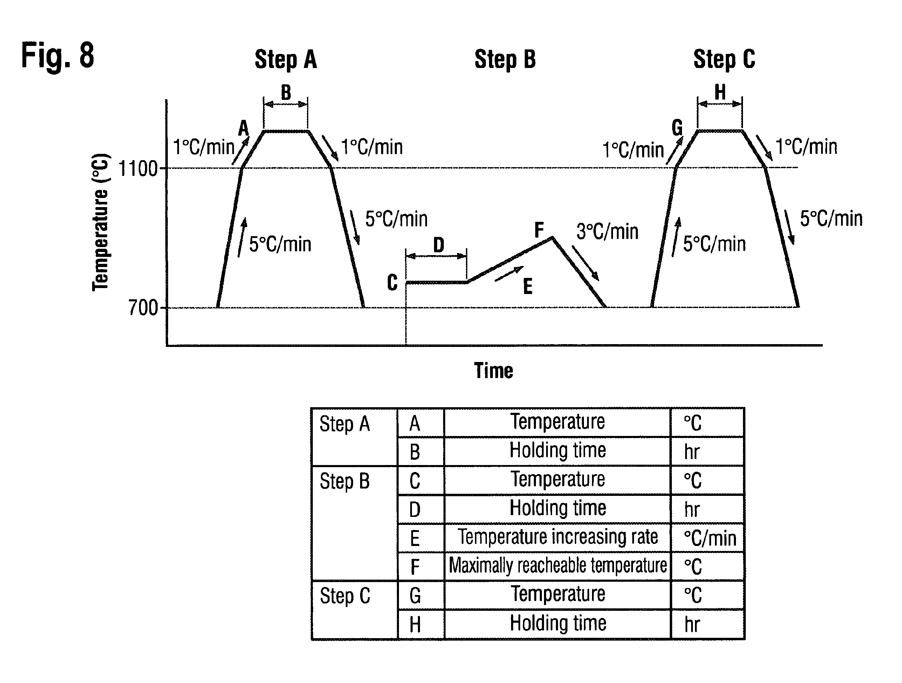

In this way, a plurality pieces of substrates were cut out from the same site of this single crystal using a wire saw, then, they were subjected to mirror finishing to obtain the silicon substrate wafer (a thickness of about 725 μm). Thereafter, the relevant silicon wafer was used as a substrate to prepare the annealed wafer, by performing heat treatment according to a heat treatment pattern shown in Fig. 8. Heat treatment was performed under atmosphere of 100% argon.

**Examples 2, 3 and 4**

Silicon wafers were produced by the same way as in Example 1, under conditions shown in the following Table 1.

(Measurement and evaluation of the annealed wafer)

On each of the annealed wafers obtained under the preparation conditions, the following measurement and evaluation were performed.

(1) Measurement of BMD density

A TEM sample was taken from position at a depth of 100 $\mu$m from the surface of the annealed wafer. The TEM sample was observed with TEM to count BMD having a diagonal length of equal to or longer than 10 nm, for at least 10 or more pieces. Volume of the observed region was calculated from total area observed with TEM and sample thickness, and volume density of BMD was calculated from BMD count number and volume of the observed region.

(2) Morphology of BMD

A TEM sample was taken from position at a depth of 100 $\mu$m from the surface of the annealed wafer. The TEM sample was observed from the <110> direction to determine the ratio of the {111} plane of BMD, according to the method of Fig. 7.

At least 10 BMDs were observed to determine an average value of the ratio of the {111} plane.

(3) Slip length

The annealed wafer was subjected to the following heat treatment using RTA. The heat treatment under the following condition was repeated 10 times.

Insertion: room temperature
Temperature increasing rate: 50°C /minute
Retention: at 1100°C for 1 minute
Temperature decreasing rate: 30°C /minute
Taking out: room temperature
Atmosphere: argon

The annealed wafer after the heat treatment was observed with an X-ray topography, and maximal length among slip lengths observed was adopted as a representative value.

(4) Amount of warpage

The annealed wafer was subjected to the following heat treatment, as the assumption of a device process.

(A) Heat treatment
780°C, 3 hours + 1000°C, 16 hours, dry oxygen atmosphere
(B) Deposition of an oxidized film
950°C, dry oxygen atmosphere, a film thickness of 15 nm
(C) Deposition of a nitride film
CVD, 780°C, a film thickness of 150 nm
(D) Heat treatment by RTA
Heat treatment under the following condition was repeated 10 times.

Insertion: room temperature
Temperature increasing rate: 50°C /minute
Retention: at 900°C for 1 minute
Temperature decreasing rate: 30°C /minute
Taking out: room temperature
Atmosphere: argon

And, warpage of each of the annealed wafers, before the pseudo device process heat treatment and after the pseudo device process heat treatment, was measured using FT-90A, manufactured by NIDEK Co., Ltd., to determine increased amount of warpage = warpage after heat treatment - warpage before heat treatment.

(Each of measurement results and evaluation results of the annealed wafers)

In Table 1, on annealed wafers prepared under preparation conditions shown in Table 1, as Examples and Comparative Examples, density and inter-lattice oxygen concentration of BMD having predetermined size measured, and slip and warpage amount, generated by the pseudo device process heat treatment, are summarized.

Table 1

| No. | H$_2$ partial pressuere (Pa) | Cooling rate of 900 to 1000°C (°C /min) | O$_2$ (atoms/cm$^3$) | N$_2$ (atoms/cm$^3$) | Carbon (atoms/cm$^3$) | Heat treatment | | | | | | | | BMD density | {111} plane ratio | Slip (mm) | Warpage (μm) |
|---|---|---|---|---|---|---|---|---|---|---|---|---|---|---|---|---|---|
| | | | | | | Step A | | Step B | | | | Step C | | | | | |
| | | | | | | A(°C) | B (hr) | C (°C) | D (hr) | E(°C /min) | F (°C) | G(°C) | H (hr) | | | | |
| Example | 1 3 | 5 | 8.5E+17 | 1.0E+15 | 5.0E+15 | 1200 | 4 | 700 | 4 | 0.5 | 750 | 1200 | 1 | 1.3E+12 | 0.03 | 7 | 0.0 |
| Example 2 | 40 | 5 | 8.3E+17 | 4.0E+14 | 7.0E+16 | 1200 | 4 | 700 | 4 | 0.5 | 750 | 1200 | 1 | 8.9E+12 | 0.10 | 5 | 0.2 |
| Example 3 | 40 | 5 | 8.5E+17 | 2.0E+14 | 1.0E+17 | 1200 | 2 | 700 | 4 | 0.5 | 750 | 1200 | 1 | 6.8E+12 | 0.08 | 3 | 0.5 |
| Example 4 | 40 | 5 | 8.0E+17 | 2.0E+14 | 1.0E+17 | 1200 | 2 | 700 | 4 | 0.5 | 750 | 1200 | 1 | 1.2E+12 | 0.09 | 9 | 0.2 |
| Comparative Example. 1 | Non | 5 | 8.5E+17 | 1.0E+15 | 1.0E+17 | 1200 | 4 | 700 | 4 | 0.5 | 750 | 1200 | 1 | 3.4E+12 | 0.32 | 6 | 11.0 |
| Comparative Example. 2 | 40 | 2 | 8.3E+17 | 1.0E+15 | 5.0E+15 | 1200 | 4 | 700 | 4 | 0.5 | 750 | 1200 | 1 | 1.2E+12 | 0.40 | 5 | 37.4 |
| Comparative Example. 3 | 40 | 5 | 8.8E+17 | 1.0E+15 | Non | 1200 | 4 | 700 | 4 | 0.5 | 750 | 1200 | 1 | 5.6E+11 | 0.58 | 8 | 75.3 |
| Comparative Example. 4 | 40 | 5 | 8.4E+17 | 1.0E+15 | 5.0E+15 | Non | | 700 | 4 | 0.5 | 750 | 1200 | 1 | 6.2E+12 | 0.49 | 7 | 111.5 |
| Comparative Example. 5 | 40 | 5 | 8.9E+17 | 1.5E+15 | 6.8E+15 | 1200 | 4 | Non | | | | 1200 | 1 | 1.2E+09 | 0.72 | 34 | 0.0 |

**Claims**

1. A silicon wafer having a nitrogen concentration of from $1.5 \times 10^{14}$ atoms/cm$^3$ to $5 \times 10^{15}$ atoms/cm$^3$, having a carbon concentration of from $3 \times 10^{15}$ atoms/cm$^3$ to $2 \times 10^{17}$ atoms/cm$^3$ and having an oxygen concentration of from $8 \times 10^{17}$ atoms/cm$^3$ to $9 \times 10^{17}$ atoms/cm$^3$, and comprising BMD with a diagonal length of 10 nm to 50 nm, the diagonal length being the length in a <100> direction in a plane image of BMD projected orthogonally to any one of the {110} planes, wherein, a density of said BMD which exists at a position of a depth of equal to or deeper than 50 μm from a surface of said silicon wafer is equal to or higher than $1 \times 10^{11}$/cm$^3$, and a ratio of {111} plane in total planes surrounding BMD, as morphology of said BMD, is equal to or lower than 0.3, wherein said ratio is determined as the ratio of length of the {111} plane to total length of the circumference, when BMD is projected in a <110> direction.

2. A method for producing a silicon wafer having a nitrogen concentration of from $1.5 \times 10^{14}$ atoms/cm$^3$ to $5 \times 10^{15}$ atoms/cm$^3$, having a carbon concentration of from $3 \times 10^{15}$ atoms/cm$^3$ to $2 \times 10^{17}$ atoms/cm$^3$ and having an oxygen concentration of from $8 \times 10^{17}$ atoms/cm$^3$ to $9 \times 10^{17}$ atoms/cm$^3$, comprising the steps of pulling a silicon crystal and setting a partial pressure of hydrogen inside a crystal pull-up furnace for growing said silicon crystal at 3 to 40 Pa and cooling the silicon crystal with a cooling rate at 1000°C to 900°C which is equal to or higher than 5°C/minute; obtaining a silicon substrate wafer by cutting out the silicon crystal; subjecting the silicon substrate wafer to heat treatment step (A), heat treatment step (B) and heat treatment step (C):

   (A) the heat treatment step (A) comprising the steps of:

   inserting said silicon substrate wafer to a heat treatment furnace by setting a temperature thereof at 700°C to 800°C;
   increasing the temperature at a temperature increasing rate of 5°C/minute to 10°C/minute for a range of the insertion temperature of said silicon substrate wafer to a temperature of below 1100°C; increasing the temperature at a temperature increasing rate of 1°C/minute to 2°C/minute for a temperature range of 1100°C to 1250°C; keeping the temperature to be a constant temperature of 1200°C to 1250°C for from 2 to 4 hours;
   decreasing the temperature of said heat treatment furnace at a temperature decreasing rate of 1°C/minute to 10°C/minute;
   taking out said silicon substrate wafer to outside of said heat treatment furnace at a temperature of 700°C to 800°; and
   cooling said silicon substrate wafer down to room temperature;

   (B) the heat treatment step (B) comprising the steps of:

   inserting said silicon substrate wafer to the heat treatment furnace by setting a temperature thereof at from 700°C to 800°C; performing a heat treatment at the temperature being a constant temperature of 700°C to 800°C for 30 minutes to 5 hours; increasing the temperature at a temperature increasing rate of 0.5°C/minute to 2°C/minute, up to a temperature in which + 50°C is added to the constant temperature or higher; decreasing the temperature of said heat treatment furnace at a temperature decreasing rate of 1°C/minute to 10°C/minute;
   taking out said silicon substrate wafer to outside of the furnace at a temperature of 700°C to 800°C; and
   cooling the substrate down to room temperature;

   (C) the heat treatment step (C) comprising the steps of:

   inserting said silicon substrate wafer to the heat treatment furnace by setting the temperature thereof at 700°C to 800°C;
   increasing the temperature at a temperature increasing rate of 5°C/minute to 10°C/minute for a range of the insertion temperature of said silicon substrate wafer to a temperature of below 1100°C; increasing the temperature at a temperature increasing rate of 1°C/minute to 2°C/minute for a temperature range of from 1100°C to 1250°C; keeping the temperature to be a constant temperature of 1200°C to 1250°C for from 1 to 4 hours; decreasing the temperature of said heat treatment furnace at a temperature decreasing rate of 1°C/minute to 10°C/minute; and taking out said silicon substrate wafer to outside of said heat treatment furnace at a temperature of from 700°C to 800°C.

3. The method for producing the silicon wafer according to claim 2, wherein setting a partial pressure of hydrogen inside a crystal pull-up furnace for growing said silicon crystal at 3 to 40 Pa and controlling a cooling rate of said silicon crystal in 1000°C to 900°C to be equal to or higher than 5°C/minute; setting an oxygen concentration of the silicon substrate wafer to be from $8 \times 10^{17}$ atoms/cm$^3$ to $9 \times 10^{17}$ atoms/cm$^3$; and setting a carbon concentration of the silicon substrate wafer to be from $3 \times 10^{15}$ atoms/cm$^3$ to $2 \times 10^{17}$ atoms/cm$^3$ and setting the nitrogen concentration of the silicon substrate wafer to be from $4 \times 10^{14}$ atoms/cm$^3$ to $5 \times 10^{15}$ atoms/cm$^3$.

**Patentansprüche**

1. Siliziumwafer mit einer Stickstoffkonzentration zwischen 1,5 x 10$^{14}$ Atome/cm$^3$ und 5 x 10$^{15}$ Atome/cm$^3$, mit einer Kohlenstoffkonzentration zwischen 3 x 10$^{15}$ Atome/cm$^3$ und 2 x 10$^{17}$ Atome/cm$^3$ und mit einer Sauerstoffkonzentration zwischen 8 x 10$^{17}$ Atome/cm$^3$ und 9 x 10$^{17}$ Atome/cm$^3$ und umfassend einen BMD mit einer Diagonallänge von zwischen 10 nm und 50 nm, wobei die Diagonallänge die Länge in einer <100>-Richtung in einer Bildebene des BMD orthogonal projiziert auf eine beliebige der {110}-Ebenen ist, wobei eine Dichte des BMD, der an einer Position einer Tiefe gleich oder tiefer als 5 0 μm von einer Oberfläche des Siliziumwafers existiert, größer oder gleich 1 x 10$^{11}$/cm$^3$ ist, und einem Verhältnis der {111}-Ebene in allen Ebenen um den BMD herum, als Morphologie des BMD, kleiner oder gleich 0,3 ist, wobei das Verhältnis bestimmt wird als das Verhältnis der Länge der {111}-Ebene zur Gesamtlänge des Umfangs, wenn der BMD in einer <110>-Richtung projiziert wird.

2. Verfahren zum Herstellen eines Siliziumwafers mit einer Stickstoffkonzentration zwischen 1,5 x 10$^{14}$ Atome/cm$^3$ und 5 x 10$^{15}$ Atome/cm$^3$, mit einer Kohlenstoffkonzentration zwischen 3 x 10$^{15}$ Atome/cm$^3$ und 2 x 10$^{17}$ Atome/cm$^3$ und mit einer Sauerstoffkonzentration zwischen 8 x 10$^{17}$ Atome/cm$^3$ und 9 x 10$^{17}$ Atome/cm$^3$, umfassend die Schritte des Ziehens eines Silizumkristalls und Setzen eines Partialdrucks von Wasserstoff in einem Kristallziehofen zum Aufwachsen des Siliziumkristalls bei 3 bis 40 Pa und Kühlen des Siliziumkristalls mit einer Kühlrate bei 1000°C bis 900°C, die größer oder gleich 5°C/Minute ist; Erhalten eines Siliziumsubstratwafers durch Herausschneiden des Siliziumkristalls; Unterziehen des Siliziumsubstratwafers einem Wärmebehandlungsschritt (A), einem Wärmebehandlungsschritt (B) und einem Wärmebehandlungsschritt (C):

(A) wobei der Wärmebehandlungsschritt (A) die folgenden Schritte umfasst:

Einsetzen des Siliziumsubstratwafers in einen Wärmebehandlungsofen durch Setzen einer Temperatur davon auf 700°C bis 800°C; Erhöhen der Temperatur mit einer Temperatursteigerungsrate von 5°C/Minute bis 10°C/Minute für einen Bereich der Einführungstemperatur des Siliziumsubstratwafers auf eine Temperatur unter 1100°C; Erhöhen der Temperatur mit einer Temperaturerhöhungsrate von 1°C/Minute bis 2°C/Minute für einen Temperaturbereich von 1100°C bis 1250°C;
Halten der Temperatur als eine konstante Temperatur von 1200°C bis 1250°C für 2 bis 4 Stunden; Senken der Temperatur des Wärmebehandlungsofens mit einer Temperatursenkungsrate von 1°C/Minute bis 10°C/Minute;
Herausnehmen des Siliziumsubstratwafers zur Außenseite des Wärmebehandlungsofens bei einer Temperatur von 700°C bis 800°C; und Kühlen des Siliziumsubstratwafers herunter auf Raumtemperatur;

(B) wobei der Wärmebehandlungsschritt (B) die folgenden Schritte umfasst:

Einsetzen des Siliziumsubstratwafers in dem Wärmebehandlungsofen durch Setzen einer Temperatur davon auf von 700°C bis 800°C; Durchführen einer Wärmebehandlung mit der Temperatur, die eine konstante Temperatur von 700°C bis 800°C ist, für 30 Minuten bis 5 Stunden; Erhöhen der Temperatur mit einer Temperaturerhöhungsrate von 0,5°C/Minute bis 2°C/Minute, bis zu einer Temperatur, bei der + 50°C zu der konstanten Temperatur oder höher addiert wird; Senken der Temperatur des Wärmebehandlungsofens mit einer Temperatursenkungsrate von 1°C/Minute bis 10°C/Minute;
Herausnehmen des Siliziumsubstratwafers zur Außenseite des Ofens bei einer Temperatur von 700°C bis 800°C; und
Kühlen des Substrats herunter auf Raumtemperatur;

(C) wobei der Wärmebehandlungsschritt (C) die folgenden Schritte umfasst:

Einsetzen des Siliziumsubstratwafers in den Wärmebehandlungsofen durch Setzen einer Temperatur davon auf 700°C bis 800°C; Erhöhen der Temperatur mit einer Temperatursteigerungsrate von 5°C/Minute bis 10°C/Minute für einen Bereich der Einführungstemperatur des Siliziumsubstratwafers auf eine Temperatur von u n t e r 1100°C; Erhöhen der Temperatur mit einer Temperaturerhöhungsrate von 1°C/Minute bis 2°C/Minute für einen Temperaturbereich von 1100°C bis 1250°C;

Halten der Temperatur als eine konstante Temperatur von 1200°C bis 1250°C für 1 bis 4 Stunden; Senken der Temperatur des Wärmebehandlungsofens mit einer Temperatursenkungsrate von 1°C/Minute bis 10°C/ Minute;

und Herausnehmen des Siliziumsubstratwafers zur Außenseite des Wärmebehandlungsofens bei einer Temperatur von 700°C bis 800°C.

3. Verfahren zum Herstellen des Siliziumwafers nach Anspruch 2, wobei ein Partialdruck von Wasserstoff in einem Kristallziehofen zum Aufwachsen des Siliziumkristalls mit 3 bis 40 Pa eingestellt wird und eine Kühlrate des Siliziumkristalls in 1000°C bis 900°C größer oder gleich 5°C/Minute gesteuert wird; eine Sauerstoffkonzentration des Siliziumsubstratwafers zwischen $8 \times 10^{17}$ Atome/cm$^3$ und $9 \times 10^{17}$ Atome/cm$^3$ eingestellt wird; und eine Kohlenstoffkonzentration des Siliziumsubstratwafers zwischen $3 \times 10^{15}$ Atome/cm$^3$ und $2 \times 10^{17}$ Atome/cm$^3$ eingestellt wird; und die Stickstoffkonzentration des Siliziumsubstratwafers zwischen $4 \times 10^{14}$ Atome/cm$^3$ und $5 \times 10^{15}$ Atome/cm$^3$ eingestellt wird.

**Revendications**

1. Plaquette de silicium ayant une concentration d'azote de $1,5.10^{14}$ atomes/cm$^3$ à $5.10^{15}$ atomes/cm$^3$, ayant une concentration de carbone de $3.10^{15}$ atomes/cm$^3$ à $2.10^{17}$ atomes/cm$^3$ et ayant une concentration d'oxygène de $8.10^{17}$ atomes/cm$^3$ à $9.10^{17}$ atomes/cm$^3$, et comprenant un microdéfaut volumique (BMD) avec une longueur diagonale de 10 nm à 50 nm, la longueur diagonale étant la longueur dans une direction <100> dans une image plane du BMD projeté orthogonalement à l'un quelconque des plans {110}, dans laquelle la densité dudit BMD qui existe à une position en profondeur égale ou supérieure à 50 μm par rapport à une surface de ladite plaquette de silicium est égale ou supérieure à $1.10^{11}$/cm$^3$, et la proportion du plan {111} parmi la totalité des plans entourant le BMD, en tant que morphologie dudit BMD, est égale ou inférieure à 0,3, ladite proportion étant déterminée comme le rapport entre la longueur du plan {111} et la longueur totale de la circonférence, quand le BMD est projeté dans une direction <110>.

2. Procédé de production d'une plaquette de silicium ayant une concentration d'azote de $1,5.10^{14}$ atomes/cm$^3$ à $5.10^{15}$ atomes/cm$^3$, ayant une concentration de carbone de $3.10^{15}$ atomes/cm$^3$ à $2.10^{17}$ atomes/cm$^3$ et ayant une concentration d'oxygène de $8.10^{17}$ atomes/cm$^3$ à $9.10^{17}$ atomes/cm$^3$, comprenant les étapes consistant à tirer un cristal de silicium et établir une pression partielle d'hydrogène à l'intérieur d'un four de tirage de cristaux pour faire croître ledit cristal de silicium à 3 à 40 Pa et refroidir le cristal de silicium à une vitesse de refroidissement de 1000 °C à 900 °C qui est égale ou supérieure à 5 °C/minute ; obtenir une plaquette substrat de silicium en découpant le cristal de silicium ; et soumettre la plaquette substrat de silicium à une étape de traitement thermique (A), une étape de traitement thermique (B) et une étape de traitement thermique (C) :

(A) l'étape de traitement thermique (A) comprenant les étapes consistant à : insérer ladite plaquette substrat de silicium dans un four de traitement thermique en réglant la température de celui-ci à 700 °C à 800 °C ; élever la température à une vitesse de montée en température de 5 °C/minute à 10 °C/minute pour une plage allant de la température d'insertion de ladite plaquette substrat de silicium jusqu'à une température inférieure à 1100 °C ; élever la température à une vitesse de montée en température de 1 °C/minute à 2 °C/minute pour une plage de température de 1100 °C à 1250 °C ; maintenir la température pour obtenir une température constante de 1200 °C à 1250 °C pendant 2 à 4 heures ; baisser la température dudit four de traitement thermique à une vitesse de baisse de température de 1 °C/minute à 10 °C/minute ; retirer ladite plaquette substrat de silicium dudit four de traitement thermique à une température de 700 °C à 800 °C ; et refroidir ladite plaquette substrat de silicium jusqu'à la température ambiante ;

(B) l'étape de traitement thermique (B) comprenant les étapes consistant à : insérer ladite plaquette substrat de silicium dans le four de traitement thermique en réglant la température de celui-ci à 700 °C à 800 °C ; effectuer un traitement thermique à une température étant une température constante de 700 °C à 800 °C pendant 30 minutes à 5 heures ; élever la température à une vitesse de montée en température de 0,5 °C/minute à 2 °C/ minute jusqu'à une température pour laquelle +50 °C ou plus sont ajoutés à la température constante ; baisser la température dudit four de traitement thermique à une vitesse de baisse de température de 1 °C/minute à 10 °C/minute ; retirer ladite plaquette substrat de silicium du four à une température de 700 °C à 800 °C ; et refroidir le substrat jusqu'à la température ambiante ;

(C) l'étape de traitement thermique (C) comprenant les étapes consistant à : insérer ladite plaquette substrat de silicium dans le four de traitement thermique en réglant la température de celui-ci à 700 °C à 800 °C ; élever la température à une vitesse de montée en température de 5 °C/minute à 10 °C/minute pour une plage allant de la température d'insertion de ladite plaquette substrat de silicium jusqu'à une température inférieure à 1100 °C ; élever la température à une vitesse de montée en température de 1 °C/minute à 2 °C/minute pour une plage de température de 1100 °C à 1250 °C ; maintenir la température pour obtenir une température constante de 1200 °C à 1250 °C pendant 1 à 4 heures ; baisser la température dudit four de traitement thermique à une vitesse de baisse de température de 1 °C/minute à 10 °C/minute ; et retirer ladite plaquette substrat de silicium dudit four de traitement thermique à une température de 700 °C à 800 °C.

3. Procédé de production de la plaquette de silicium selon la revendication 2, comprenant l'établissement d'une pression partielle d'hydrogène à l'intérieur du four de tirage de cristaux pour faire croître ledit cristal de silicium à 3 à 40 Pa et le contrôle de la vitesse de refroidissement dudit cristal de silicium de 1000 °C à 900 °C pour qu'elle soit égale ou supérieure à 5 °C/minute ; le réglage de la concentration d'oxygène de la plaquette substrat de silicium pour qu'elle soit égale à $8.10^{17}$ atomes/cm$^3$ à $9.10^{17}$ atomes/cm$^3$ ; le réglage de la concentration de carbone de la plaquette substrat de silicium pour qu'elle soit égale à $3.10^{15}$ atomes/cm$^3$ à $2.10^{17}$ atomes/cm$^3$ ; et le réglage de la concentration d'azote de la plaquette substrat de silicium pour qu'elle soit égale à $4.10^{14}$ atomes/cm$^3$ à $5.10^{15}$ atomes/cm$^3$.

**Fig. 1**

# Fig. 2

(1)

(1-a)

(1-b)

(2)

(2-a)

(2-b)

Fig. 3

(1)
(1-a)
(1-b)

(2)
(2-a)
(2-b)

# Fig. 4

[001]  [111]

[110]

[1̄10]

[11̄1̄]

50nm

# Fig. 5

Precipitate

Dislocation generation site

{111}

{111}

[001]

[010]

[100]

Dislocation

Precipitate

[001]

[110]  [Ī10]

Dislocation

EP 2 345 753 B1

# Fig. 6

Dislocation

Octahedral BMD

[001] [111]
[110]
[1Ī0]
[11Ī]
50nm

# Fig. 7

Ratio of the {111} plane in the total planes surrounding BMD

Large                                                                Small

Warpage after heat treatment

Large                                                                Small

(a)                    (a)                    (a)                    (a)

Ratio of the          Ratio of the          Ratio of the          Ratio of the
{111} plane           {111} plane           {111} plane           {111} plane
1                                                                   0

$$\frac{b+c+e+f}{a+b+c+d+e+f}$$        $$\frac{b}{a+b}$$

[001]  [$\bar{1}$11]
[$\bar{1}$10]
[110]
[$\bar{1}$1$\bar{1}$]

# Fig. 8

| Step A | A | Temperature | °C |
|--------|---|-------------|-----|
| | B | Holding time | hr |
| Step B | C | Temperature | °C |
| | D | Holding time | hr |
| | E | Temperature increasing rate | °C/min |
| | F | Maximally reacheable temperature | °C |
| Step C | G | Temperature | °C |
| | H | Holding time | hr |

EP 2 345 753 B1

# Fig. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008166721 A
- JP 2008160069 A
- JP 2009164155 A
- EP 1406294 A1
- WO 9320582 A1
- JP 58056343 A

- EP 0502471 A2
- US 6222252 B1
- JP 8213403 A
- JP 2006040980 A
- WO 03060982 A2

**Non-patent literature cited in the description**

- **Seigo Kishino et al.** *Japanese Journal of Applied Physics,* 31 January 1984, vol. 23, L9-L.11
- **Fumio Shimura.** *Semiconductor Silicon Crystal Technology,* 01 January 1989, 361-367

- **P. Fraundorf et al.** *Journal of Applied Physics,* 01 December 1985, vol. 58 (11), 4049-4055
- **W. Zulehner ; D. Huber.** Crystal Growth, Properties and Applications. Springer-Verlag, 1982, 28